**Europäisches Patentamt**

**European Patent Office**

**Office européen des brevets**

(19)

(11) Veröffentlichungsnummer : **0 072 565 B1**

(12) **EUROPÄISCHE PATENTSCHRIFT**

(45) Veröffentlichungstag der Patentschrift :
04.03.87

(21) Anmeldenummer : 82107466.3

(22) Anmeldetag : 17.08.82

(51) Int. Cl.⁴ : **C 30 B 15/06, C 30 B 15/36, C 30 B 33/00**

(54) Verfahren zur Herstellung grob- bis einkristalliner Folien aus Halbleitermaterial.

(30) Priorität : 19.08.81 DE 3132776

(43) Veröffentlichungstag der Anmeldung :
23.02.83 Patentblatt 83/08

(45) Bekanntmachung des Hinweises auf die Patenterteilung : 04.03.87 Patentblatt 87/10

(84) Benannte Vertragsstaaten :
AT BE CH DE FR GB IT LI NL

(56) Entgegenhaltungen :
EP-A- 0 013 985
DE-A- 2 830 522
DE-A- 2 837 775
DE-A- 3 017 016
US-A- 4 251 570

(73) Patentinhaber : HELIOTRONIC Forschungs- und Entwicklungsgesellschaft für Solarzellen-Grundstoffe mbH
Johannes-Hess-Strasse 24
D-8263 Burghausen (DE)

(72) Erfinder : Geissler, Joachim, Dipl.-Ing.
Rosenstrasse 24
D-8261 Stammham (DE)
Erfinder : Helmreich, Dieter, Dr. Dipl.-Ing.
Robert-Koch-Strasse 185
D-8263 Burghausen (DE)

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Gegenstand der Erfindung ist ein Verfahren zur Herstellung grob- bis einkristalliner vorzugsorientierter Folien und/oder Platten aus Halbleitermaterial, bei dem schmelzflüssiges Halbleitermaterial auf einen Substratkörper aus dem selben, grob- bis einkristallinen Halbleitermaterial aufgebracht wird und sich nach dem Erstarren aufgrund thermischer Spannungen vom Substratkörper selbsttätig ablöst.

Solarzellen, wie sie in der Raumfahrt als Stromerzeuger eingesetzt werden, sind viel zu teuer für eine breite terrestrische Anwendung. Der Hauptgrund für den hohen Preis liegt in dem arbeits- und materialaufwendigen Herstellungsprozeß, nach dem durch Tiegel- oder Zonenziehen gewonnene einkristalline Siliciumstäbe oder -barren unter beträchtlichem Materialverlust zu einkristallinen Siliciumscheiben zersägt werden.

Die Umgehung dieses kostspieligen und verlustreichen Sägeschrittes ist das Ziel zahlreicher inzwischen bekanntgewordener Verfahren, in denen versucht wird, Silicium direkt in Platten- oder Folienform zu erhalten. Dies erfolgt beispielsweise dadurch, daß aus einem polykristallinen Siliciumvorratsstab über eine formgebende Düse ein einkristallines Siliciumband gezogen wird. Nach dem EFG-Verfahren wird z. B. über einen, in eine Siliciumschmelze eintauchenden formgebenden Kapillarkörper aus Kohlenstoff monokristallines Silicium in Bandform nach oben abgezogen. Nach dem Verfahren von Bleil wird Silicium in einem Schmelztiegel aufgeschmolzen und seitwärts mit einem Keimkristall ein Siliciumband unter der Einwirkung eines Temperaturgradienten abgezogen, wobei die konstante Schmelzhöhe im Tiegel durch ein System von in die Schmelze eintauchenden Verdrängungskörpern gewährleistet wird. Nach dem Verfahren von Shockley wird schließlich bandförmiges Silicium dadurch erhalten, daß ein polykristalliner Vorratsstab auf flüssiges Blei aufgeschmolzen und von diesem Bleifilm unter der Einwirkung eines Temperaturgradienten mit Hilfe eines Keimkristalls horizontal als Band abgezogen wird. Die Wirtschaftlichkeit der genannten Verfahren wird allerdings durch die geringen Ziehgeschwindigkeiten, die in der Größenordnung von wenigen Zentimetern in der Minute liegen, begrenzt. Beim letztgenannten Verfahren kommt noch erschwerend hinzu, daß das als Substratfläche eingesetzte Blei außerordentlich rein sein muß, damit es nicht zu einer Verunreinigung des darauf aufgeschmolzenen und wiedererstarrten Siliciums kommt. Ein weiterer Nachteil liegt in dem hohen Dampfdruck des Bleis, welcher dazu führt, daß es am kühlen Ende der Apparatur, an welcher das wiedererstarrte Silicium abgezogen wird, unvermeidlich zu Abscheidungen von Blei auf dem Siliciumband kommt. Eine umfassende Darstellung dieser und ähnlicher Verfahren findet sich in dem Artikel von Jean-Jacques Brissot « Silicium pour photopiles solaires », Acta Electronica, 20, 2, 1977, Seite 101 bis 116.

Das Verfahren nach der DE-OS-29 03 061, nach dem eine Siliciumfolie von einer Schmelze abgezogen wird, welche in einer nicht elementaren Gleitschmelze eingebettet ist, ist wegen der erforderlichen präzisen Erneuerung und Steuerung der Gleitschmelze, besonders an der Abzugsstelle, technisch schwierig zu realisieren. Vor allem können die Abdampfung und die damit verbundene Zusammensetzungsänderung, verstärkt durch Reaktionen zwischen Tiegel, Schmelze und Gleitschmelze die Gleiteigenschaften durch Viskositätsänderung ständig verändern.

Nach dem in der DE-OS-28 30 522 offengelegten Verfahren können schließlich Siliciumbänder durch Aufbringen von flüssigem Silicium auf eine einkristalline, rotierende Siliciumunterlage erhalten werden, wobei die aufgewachsenen Bänder unter Materialabtragung von der Unterlage abgeschleudert werden. Bei diesem Verfahren muß die Unterlage auf einer hohen Temperatur knapp unterhalb des Schmelzpunktes von Silicium gehalten werden ; daneben ist wegen der Materialabtragung die Unterlage nur eine begrenzte Zeit verwendbar und muß von Zeit zu Zeit erneuert werden.

Aufgabe der Erfindung war es daher, ein Verfahren anzugeben, nach dem sich mit Hilfe eines beliebig oft wiederverwendbaren Substratkörpers grob- bis einkristalline Halbleiterfolien mit hoher Ziehgeschwindigkeit herstellen lassen und dieses Verfahren zur Erzeugung von Solarzellen zu verwenden.

Gelöst wird diese Aufgabe durch ein Verfahren, welches dadurch gekennzeichnet ist, daß geschmolzenes Halbleitermaterial mit einem aus dem selben, grob- bis einkristallinen Halbleitermaterial bestehenden, mit einer Geschwindigkeit von mindestens 75 mm/s vorbeigeführten Substratkörper in Kontakt gebracht wird und daß zur selbsttätigen Ablösung der aufwachsenden Folie oder Platte der Substratkörper auf einer Temperatur von höchstens 0,8 $T_M$ gehalten wird, wobei $T_M$ der in Kelvin ausgedrückte Schmelzpunkt des eingesetzten Halbleitermaterials ist.

Bei diesem Verfahren hat es sich als zweckmäßig erwiesen, das Halbleitermaterial, aus dem die Folie hergestellt werden soll, zunächst in geeigneter Form, z. B. als Granulat im Falle von Silicium, in ein vom eigentlichen Ziehsystem getrenntes Schmelzaufbereitungsgefäß zu chargieren und es dort aufzuschmelzen. Die Schmelze wird dann über ein Verbindungssystem aus dem Schmelzaufbereitungsgefäß in das Ziehsystem übergeführt. Dies kann beispielsweise über ein Überlaufsystem in Kombination mit Verdrängungskörpern geschehen, so daß ein gleichmäßiger Zufluß des aufgeschmolzenen Halbleitermaterials zum Ziehsystem gewährleistet ist.

Als Halbleitermaterial im Sinne der Erfindung wird vorzugsweise einkomponentiges Material wie etwa Silicium oder Germanium eingesetzt, wenngleich die Erfindung auch auf mehrkomponentige Halbleitermaterialien wie beispielsweise III-V-Verbindungen, etwa Indiumphosphid, Galliumphosphid oder Galliumarsenid angewandt werden kann.

Das Ziehsystem enthält den aus Graphit oder vorzugsweise aus Quarz gefertigten Ziehtiegel. In diesem wird das aus dem Schmelzaufbereitungsgefäß abgeflossene, geschmolzene Halbleitermaterial aufgefangen und auf eine bis zu 100 °C, vorzugsweise aber 5 bis 50 °C, über dem Schmelzpunkt liegende Temperatur eingestellt. Die Heizung des Ziehtiegels kann beispielsweise durch Widerstandsheizung oder Induktionsheizung erfolgen.

Die Schmelze und der Substratkörper können beispielsweise dadurch in Kontakt gebracht werden, daß die Schmelze auf den Substratkörper aufgegossen, aufgeschleudert oder aufgespritzt wird. Eine andere Möglichkeit besteht darin, daß beispielsweise der Ziehtiegel auf einer Seite so ausgestaltet ist, daß sich das in ihm enthaltene schmelzflüssige Halbleitermaterial mit dem Substratkörper in Kontakt bringen läßt. Als besonders günstig hat es sich dabei erwiesen, das schmelzflüssige Halbleitermaterial zur Ausbildung eines durch die Oberflächenspannung stabilisierten, über den Tiegelrand hinausragenden Miniskus zu veranlassen. Dies läßt sich beispielsweise durch einfache Steuerung der Tiegelneigung erreichen. Besonders vorteilhaft ist es jedoch, wenn der Ziehtiegel auf einer Seite eine — günstig in Höhe des Tiegelbodens gelegene — schlitzartig ausgebildete Öffnung aufweist, die so dimensioniert ist, daß das schmelzflüssige Halbleitermaterial unter Meniskusbildung durch sie hindurchtreten kann. Damit kann die Ausbildung des Meniskus beispielsweise durch Schmelzentemperatur, Tiegelneigung und Schlitzdimensionierung beeinflußt werden.

Die Abmessungen der schlitzartigen Öffnung richten sich in der Höhe nach der erforderlichen Stabilität des entstehenden Meniskus, während die Schlitzbreite auf die gewünschte Breite der Folie abgestimmt wird. Besonders gute Ergebnisse lassen sich erzielen, wenn die Breite des Schlitzes 1 bis 20 mm, vorzugsweise 10 mm, größer als die Breite des Susträtkörpers ist.

Das eigentliche Ziehen der Folie geschieht dadurch, daß mit dem beschriebenen Meniskus aus geschmolzenem Halbleitermaterial ein aus dem selben, grob- bis einkristallinen Halbleitermaterial gefertigter Substratkörper in Kontakt gebracht und mit einer Geschwindigkeit von mindestens 75 mm/s daran vorbeibewegt wird. Es hat sich als günstig erwiesen, die freie Oberfläche des bei diesem Vorgang an der Kontaktstelle abgezogenen Schmelzenfilms durch eine zusätzliche Heizeinrichtung, beispielsweise ein Elektronenstrahlgerät oder eine Laserkanone, auf Schmelztemperatur zu halten. Dabei wird unter Übertragung der Vorzugsorientierung des Substratkörpers eine grob- bis einkristalline Folie auf den Substratkörper aufgezogen, die sich aufgrund thermischer Spannungen dann von selbst vom Substratkörper wieder ablöst.

Bei kontinuierlicher Arbeitsweise kann der Substratkörper beispielsweise in Form eines « endlosen Bandes » oder einer Trommel an dem Meniskus vorbeigeführt werden. Bei semikontinuierlicher Arbeitsweise können als Substratkörper auch einzelne, beispielsweise 1 m lange Rampen verwendet werden. Die Breite des jeweiligen Substratkörpers richtet sich nach der erwünschten Folien- oder Plattenbreite. In jedem Fall hat es sich aber als zweckmäßig erwiesen, die Substratkörper aus Einzelelementen zusammenzufügen, die die selben Maße wie das gewünschte Produkt, beispielsweise Solarzellen von 100 mm Länge und 100 mm Breite, aufweisen. Allerdings ist eine Vielzahl von anderen Form- und Größenvariationen denkbar.

Besonders gute Ergebnisse lassen sich erzielen, wenn die Bewegung des Substratkörpers am Meniskus vorbei von unten nach oben gerichtet ist und von der Senkrechten um 0° bis 60°, vorzugsweise 0° bis 20° abweicht. Wählt man dabei den Abstand zwischen den Einzelelementen gering, beispielsweise ⩽ 0,05 mm, so erhält man eine nicht unterteilte Folie, die dann durch geeignete Verfahrensschritte, beispielsweise Sägen oder Ritzen und anschließendes Zerbrechen in die gewünschten Einzelstücke zerteilt werden kann. Wählt man jedoch einen großen Abstand zwischen den Einzelelementen, beispielsweise von 0,5 bis ca. 2 mm, werden bereits getrennte Folienstücke in der Größe der Einzelelemente erhalten, so daß der oben angeführte Zerteilungsschritt nicht mehr nötig ist.

Wichtig für das grob- bis einkristalline Aufwachsen und die selbsttätige Ablösung der Folie vom Substratkörper ist die Temperatur des Substratkörpers. Wird sie nämlich zu niedrig gewählt, enthält die aufwachsende Folie viele der für Solarzellengrundmaterial ungünstigen mikrokristallinen Bereiche. Ist die Temperatur des Substratkörpers zu hoch, wird die Folie nach Art der Flüssigepitaxie aufwachsen ; somit ist keine selbsttätige Ablösung der Folie vom Substratkörper mehr möglich. Als besonders geeignet für die Durchführung des erfindungsgemäßen Verfahrens hat sich eine Temperaturdifferenz von etwa 0,2 bis 0,5 $T_M$, vorzugsweise etwa 0,3 bis 0,4 $T_M$ zwischen Schmelze und Substratkörper erwiesen, für Silicium beispielsweise eine Temperaturdifferenz von etwa 350–850 K, vorzugsweise 500–680 K, wenn für $T_M$ die Schmelztemperatur des Siliciums mit 1 693 K eingesetzt wird. Der Substratkörper wird zweckmäßigerweise in einem seperat regelbaren Temperiertunnel auf die gewünschte Temperatur eingestellt.

Ein wesentlicher Faktor bei der Durchführung des erfindungsgemäßen Verfahrens ist die Ziehgeschwindigkeit, mit der der Substratkörper an der Kontaktstelle mit dem schmelzflüssigen Halbleitermaterial vorbeibewegt wird. Dabei werden schon aus Gründen der Effektivität möglichst hohe Werte angestrebt. So wurden bei Anwendung des erfindungsgemäßen Verfahrens auf Silicium bereits Geschwindigkeiten von über 300 mm/s erreicht. Allgemein kann beispielsweise durch eine Erhöhung der Temperaturdifferenz zwischen Substratkörper und Schmelze die Steigerung der Ziehgeschwindigkeit begünstigt werden, die allerdings ihre Grenze darin findet, daß ab .bestimmten Grenzwerten die Kristallstruktur nicht mehr perfekt vom Substratkörper auf die Folie übertragen wird.

Neben der Temperatur und der Ziehgeschwindigkeit spielt bei dem erfindungsgemäßen Verfahren auch die Oberflächenbeschaffenheit des Substratkörpers eine Rolle. Als Faustregel läßt sich angeben, daß eine geringe Rauhtiefe eine selbsttätige Ablösung der aufgewachsenen Folie erleichtert.

Die Erfindung wird im folgenden an den in den Figuren dargestellten bevorzugten Ausführungsformen näher erläutert.

Figur 1 zeigt schematisch eine Vorrichtung im Längsschnitt, wo die Folie auf Substratkörper aufgezogen wird, die im Kontaktbereich als « endloses Band » geführt werden.

Figur 2 zeigt schematisch eine Vorrichtung im Längsschnitt, wo die Folie auf eine Rampe aufgezogen wird.

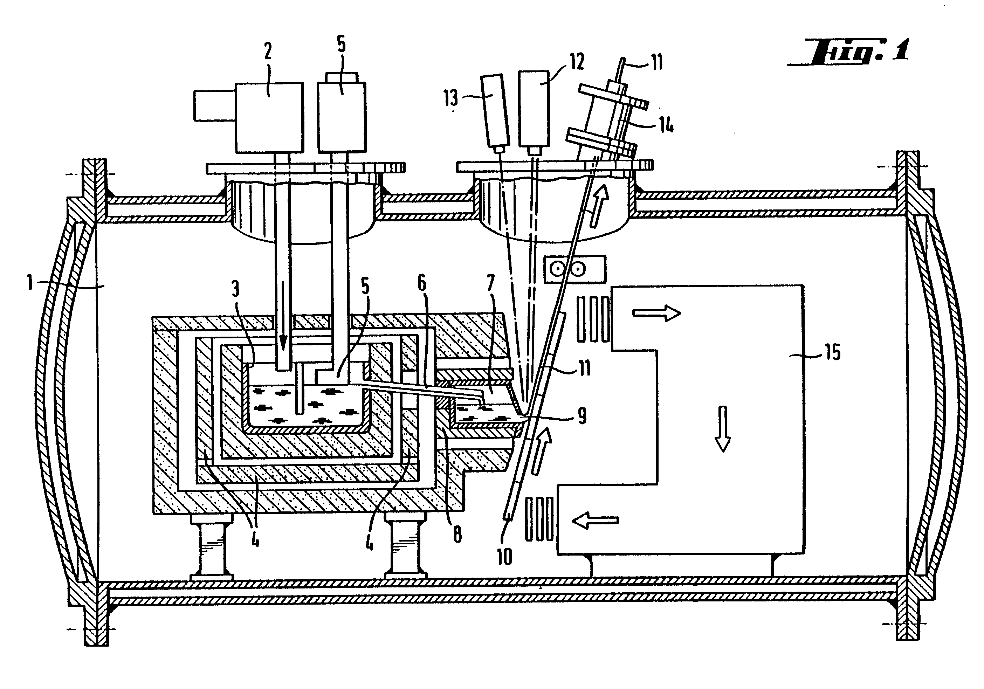

Gemäß Figur 1 ist in einem Rezipienten 1 aus beispielsweise Edelstahl, welcher zweckmäßig doppelwandig zur Aufnahme eines Kühlmediums, wie etwa Wasser, ausgeführt wird und welcher über eine Nachchargiereinrichtung 2 mit beispielsweise Siliciumgranulat beschickt werden kann, ein Schmelzaufbereitungstiegel 3 innerhalb einer Heizvorrichtung 4 angeordnet. Dieser Tiegel dient als Vorratsgefäß ; sein aufgeschmolzener Inhalt kann z. B. mit Hilfe eines oder mehrerer Verdrängungskörper 5 über ein Überlaufsystem 6 in den Ziehtiegel 7 übergeführt werden. Statt vermittels solcher Verdrängungskörper kann der Überlauf der Schmelze auch beispielsweise mittels eines Kapillarkörpers erfolgen oder durch Überpressen unter der Einwirkung eines Gasdrucks, falls ein geschlossener Schmelzaufbereitungstiegel mit einer in den Ziehtiegel einmündenden Ausflußöffnung verwendet wird.

Der über die Ziehtiegelheizung 8 durch Strahlungs-, Induktions- oder Widerstandsheizung beheizte Ziehtiegel weist an seiner Vorderseite eine schlitzartige Tiegelöffnung 9 auf, aus der das geschmolzene Halbleitermaterial unter Ausbildung eines durch Oberflächenspannung stabilisierten Meniskus austreten kann. Dieser wird mit dem beispielsweise aus aneinandergereihten Einzelplatten bestehenden Substratkörper 10 in Kontakt gebracht, der sich von unten nach oben an dem Meniskus vorbeibewegt, wobei eine Folie 11 in dünner Schicht auf den Substratkörper aufgetragen wird. Die freie Oberfläche des an der Kontaktstelle abgezogenen Schmelzenfilms der Folie 11 kann mit Hilfe der Nachheizung 12 vorzugsweise mittels Strahlungsheizung, z. B. Laserstrahlung, auf der gewünschten Temperatur gehalten werden. Die Ausbildung des Meniskus vor dem Kontakt sowie die Ausbildung der freien Oberfläche des an der Kontaktstelle abgezogenen Schmelzenfilms während des Auftragungsvorganges kann beispielsweise durch ein optisches Kontrollgerät 13 überwacht werden. Beginn und Ende des Auftragungsvorganges lassen sich besonders vorteilhaft steuern, wenn der Ziehtiegel gekippt werden kann und somit der Kontakt zwischen Schmelze und Substratkörper auf einfache Weise unterbrochen bzw. hergestellt werden kann.

Bereits wenige Sekunden nach der vollständigen Kristallisation beginnt die im Augenblick des Auftragens feste Verbindung zwischen Folie und Substratkörper sich zu lösen. Die Folie verläßt durch die Austrittsschleuse 14 den Rezipienten und kann durch beispielsweise Zersägen zu einzelnen Platten weiterverarbeitet werden, während der Substratkörper zur Wiederverwendung im Rezipienten zurückgeführt und im Temperiertunnel 15 erneut auf die gewünschte Temperatur eingestellt wird. Im Rezipienten kann eine Inertgasatmosphäre aus beispielsweise Stickstoff, Kohlendioxid, Edelgasen oder Mischungen verschiedener Inertgase vorgelegt werden ; ebenso ist aber auch ein Betrieb unter Vakuum möglich.

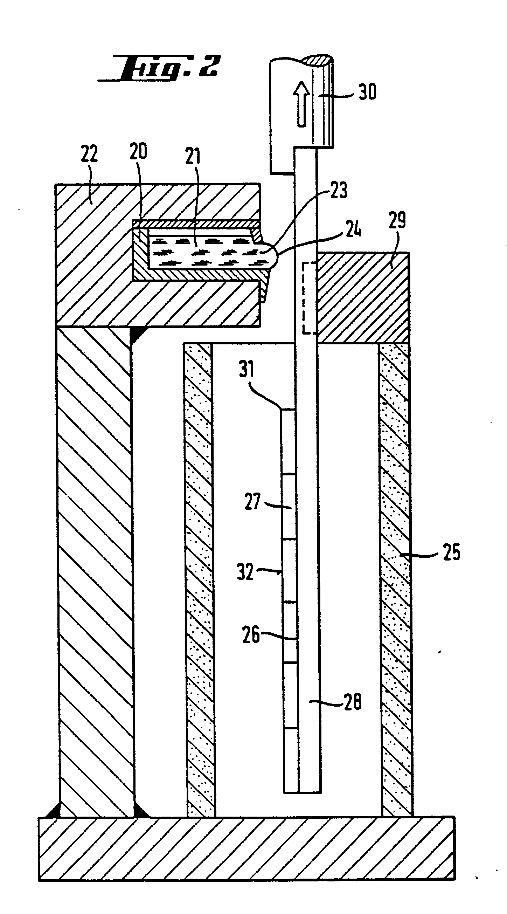

Gemäß Figur 2 kann die Folie auch auf einen als Rampe ausgebildeten Substratkörper aufgezogen werden. Aus Gründen der Übersichtlichkeit wird in Figur 2 auf eine Darstellung des Rezipienten und der Schmelzaufbereitungseinrichtung sowie eines Überleitungssystems verzichtet, da diese beispielsweise wie in der in Figur 1 beschriebenen Anordnung ausgeführt werden können.

Die in einem insbesondere aus Quarz gefertigten Ziehtiegel 20 befindliche Schmelze 21 aus Halbleitermaterial wird vermittels einer Heizeinrichtung 22, beispielsweise eines Graphitschmelzheizers auf einer mindestens 5 °C über dem Schmelzpunkt liegenden Temperatur gehalten. An der Vorderseite des Ziehtiegels ist eine schlitzartige Tiegelöffnung 23 vorgesehen, aus der ein durch Oberflächenspannung stabilisierter Meniskus 24 des schmelzflüssigen Halbleitermaterials zumindest 0,5 mm hervortritt.

In einem seperat steuerbaren Temperiertunnel 25 wird ein als bewegliche Rampe 26 ausgebildeter Substratkörper auf einer innerhalb 0,5 bis 0,8, vorzugsweise 0,6 bis 0,7 $T_M$ gelegenen Temperatur gehalten, bei Silicium also beispielsweise innerhalb einer Temperatur von 850 bis 1 350 K, vorzugsweise 1 000 bis 1 200 K (gerundete Zahlenwerte). Die Rampe besteht aus grob- bis einkristallinen Bauelementen 27 aus dem selben Halbleitermaterial, wie es sich auch schmelzflüssig im Ziehtiegel befindet. Diese Bauelemente sind zweckmäßig auf einen aus geeignetem Trägermaterial, z. B. Graphit, gefertigten Schlitten 28 montiert. Dieser Schlitten läßt sich mittels einer Führung 29 und einer Hubvorrichtung 30 in genau eingehaltenem Abstand von der Ziehtiegelvorderseite aus dem Temperiertunnel an dem Ziehtiegel vorbei nach oben bewegen. Dabei kommt zunächst die Rampenkante 31 und dann die Rampenfläche 32 in Kontakt mit dem Meniskus aus Halbleitermaterial und überzieht sich mit einer je nach Rampenmaterial grob- bis einkristallinen Folie, die bereits kurz nach dem Erstarren nur noch schwach auf der Rampe haftet und ohne Schwierigkeiten etwa mittels geeigneter Greifvorrichtungen abgenommen und zu Solarzellenmaterial weiterverarbeitet werden kann.

Wählt man den Abstand zwischen den einzelnen Bauelementen, aus denen die Rampe zusammengesetzt ist, genügend groß, so erhält man keine durchgehende Folie, sondern bereits voneinander getrennte Folienstücke, beispielsweise Platten mit den Maßen der Bauelemente. Durch die Wahl der Rampentemperatur und die Geschwindigkeit, mit der die Rampe bewegt wird, kann auf einfache Weise auch die Dicke der erhaltenen Folie bestimmt werden, so daß es gelingt, in einem Arbeitsgang Teile aus Halbleitermaterial herzustellen, die eine gewünschte Breite, Länge und Dicke besitzen.

Verwendet man eine Reihe von Rampen, die beispielsweise in der Form eines Kreises oder eines endlosen Bandes angeordnet sind und die nacheinander an dem Meniskus vorbeibewegt werden, so läßt sich dieser Prozeß auch in günstiger Weise kontinuierlich ausführen, da die Rampen beliebig oft wieder verwendbar sind.

Somit bietet das erfindungsgemäße Verfahren einen Weg, in rationeller Weise Halbleitermaterial für billiges Solarzellengrundmaterial herzustellen.

Beispiel 1

In einer Vorrichtung, wie sie in Figur 1 dargestellt ist, wird in einem als Scheidewandtiegel gestalteten Schmelzaufbereitungstiegel kontinuierlich Silicium erschmolzen, das als Granulat von 1 bis 5 mm Körnung mit ca. 21 g/s zuchargiert wird. Statt in Granulatform kann das Silicium auch durch direktes Abschmelzen von einem Polysiliciumstab in den Schmelzaufbereitungstiegel oder bei entsprechender Steuerung der Abschmelzmenge auch unmittelbar in den Ziehtiegel eingebracht werden.

Die im Schmelzaufbereitungstiegel auf 1 430 °C gehaltene Schmelze wird mittels Verdränger entsprechend der nachchargierten Siliciummenge in den Ziehtiegel übergeführt und dort auf einen Schmelzenpegel von ca. 11 mm bei horizontaler Tiegelstellung geregelt. Der Ziehtiegel besitzt eine schlitzartige Öffnung von 6 mm Höhe und 110 mm Breite, durch die das schmelzflüssige Silicium unter Ausbildung eines durch durch die Oberflächenspannung stabilisierten Meniskus hindurchtritt. Die Temperatur am ca. 1 mm betragenden Überhang wird mittels Laserheizung auf 1 430 °C gehalten.

Der bei dem erfindungsgemäßen Verfahren verwendeten Substratkörper setzt sich aus neunzig 100 × 100 mm großen, 10 mm dicken vorzugsorientierten einkristallinen Platten aus Silicium zusammen, deren Oberflächenrauhtiefe etwa 1 bis 2 $\mu$m beträgt. Diese Platten werden in einem Kreislauf derart geführt, daß sie sich ab etwa 250 mm vor der Kontaktstelle Schmelze-Substratkörper und auf eine Länge von 500 mm in der Art eines « endlosen Bandes » mit einer Geschwindigkeit von 300 mm/s von unten nach oben im Abstand von 0,5 mm am Ziehtiegel vorbeibewegen. Die Richtung des « endlosen Bandes » weicht dabei um etwa 20° von der Senkrechten ab ; der Abstand der Platten untereinander ist ≤ 0,05 mm. Nach Durchlaufen dieses Führungsbereichs werden die Siliciumplatten auf eine Geschwindigkeit von ca. 35 mm/s verlangsamt, durchlaufen einen Temperiertunnel, wo sie auf eine Temperatur von 680 °C eingestellt werden und gelangen schließlich wieder in den Bereich, wo sie als « endloses Band » geführt sind.

Das Auftragen der Siliciumfolie auf den bewegten Substratkörper geschieht dadurch, daß dieser durch Kippen des Ziehtiegels um etwa 2° mit dem Meniskus des geschmolzenen Siliciums in Kontakt gebracht wird. Die auf diese Weise aufgetragene Folie löst sich bereits unmittelbar nach dem Abkühlen auf Substrattemperatur selbsttätig vom Substratkörper. Dieser wird in den Temperiertunnel zurückgeführt und dort erneut auf eine Temperatur von 680 °C eingestellt. Die abgelöste, 0,3 mm dicke Folie wird durch die Vakuumschleuse aus dem auf ca. $10^{-3}$ mbar evakuierten Rezipienten herausgeführt und durch Laser-Ritzen in einkristalline Platten von 100 mm Länge und 100 mm Breite zerteilt, die die Vorzugsorientierung des Substratkörpers aufweisen.

Beispiel 2

In einer Vorrichtung, wie sie in Figur 2 dargestellt ist, wurden 85 g Silicium aufgeschmolzen und nach und nach in den Ziehtiegel übergeleitet, wo die Schmelze auf eine Temperatur von 1 450 °C eingestellt wurde. Der Ziehtiegel besaß eine schlitzartige Öffnung von 5 mm Höhe und 60 mm Breite, durch die ein Meniskus geschmolzenen Siliciums mit einem Überhang von 2 mm austrat. Die Temperatur am Überhang, die mittels Strahlungspyrometer gemessen wurde, betrug 1 450 °C.

Der bei dem erfindungsgemäßen Verfahren verwendete, als Rampe ausgebildete Substratkörper war aus zehn 50 × 50 mm großen, 8 mm dicken Platten aus grobkristallinen Silicium mit einer durchschnittlichen Kristallitgröße von 5 bis 10 mm gefertigt, wobei die Oberfläche eine Rauhtiefe von ca. 2 $\mu$m besaß. Der Abstand der Platten untereinander betrug 0,04 mm ; die Platten waren auf einem Schlitten aus Graphit befestigt. Die gesamte Rampe wurde zunächst in einem widerstandsbeheizten Temperiertunnel auf einer Temperatur von 900 °C gehalten.

Nun wurde die Rampe vermittels Hubvorrichtung und genauer Führung in einem Abstand von 1 mm an dem aus der schlitzartigen Öffnung des Ziehtiegels ausgetretenen Miniskus senkrecht von unten nach oben mit einer Geschwindigkeit von 80 mm/s vorbeibewegt. Beginnend mit dem ersten Kontakt zwischen Rampe und Meniskus wurden die Siliciumplatten, aus denen die Rampe zusammengebaut war, mit einer zunächst flüssigen und rasch erstarrenden Folie aus Silicium überzogen. Diese Folie begann sich bereits während des Abkühlens von Schmelztemperatur auf Rampentemperatur abzutrennen. Schließlich lag die Folie, durch Adhäsionskräfte gehalten, auf der Rampe auf und ließ sich von der Unterlage abnehmen. Die erhaltene Folie war 500 mm lang, 50 mm breit und besaß eine Dicke von 0,3 mm. Sie wies die selbe grobkristalline Struktur wie die als Substrätkörper verwendeten Siliciumplatten auf. Nach dem Abnehmen der Folie konnte die Rampe erneut für den Folienziehprozeß verwendet werden. Während des gesamten Prozesses lag in dem Rezipienten eine Argonatmosphäre mit einem Druck von 10 mbar vor.

Beispiel 3

Gemäß diesem Beispiel wurde wie unter Beispiel 2 angegeben verfahren. Jedoch bestand die verwendete Rampe aus zehn 50 × 50 mm großen, 8 mm dicken Platten aus einkristallinen Silicium, die in einem Abstand von 0,8 mm auf einen Beispiel 2 entsprechenden Graphitschlitten montiert waren. In diesem Fall konnten durch den Ziehprozeß zehn voneinander getrennte, nahezu völlig einkristalline vorzugsorientierte Siliciumplatten von 50 mm Länge, 50 mm Breite und 0,3 mm Dicke erhalten werden.

Beispiel 4

In der in Figur 2 dargestellten Vorrichtung werden 120 g Germanium aufgeschmolzen und nach und nach in den mit einer schlitzartigen Öffnung von 3 mm Höhe und 60 mm Breite versehenen Ziehtiegel übergeleitet. Die Schmelze wird auf 950 °C gehalten und bildet einen Meniskus von ca. 1 mm Überhang aus.

Die verwendete Rampe besteht aus sechs 50 × 50 mm großen, 4 mm dicken Platten aus einkristallinem Germanium mit einer Rauhtiefe von ca. 2 μm. Diese sind in einem Abstand von 0,04 mm auf einem Schlitten aus Graphit befestigt. Zunächst wird die gesamte Rampe in einem widerstandsbeheizten Temperiertunnel auf 575 °C gehalten.

Nun wird die Rampe nach dem in Beispiel 2 beschriebenen Verfahren mit einer Geschwindigkeit von 120 mm/s in einem Abstand von 0,5 mm am Ziehtiegel vorbeibewegt, eine Germaniumfolie abgezogen und diese schließlich von der wiederverwendbaren Unterlage abgenommen.

Die erhaltene, vorzugsorientierte und einkristalline Germaniumfolie ist 300 mm lang, 50 mm breit und besitzt eine Dicke von 0,25 mm. Während des gesamten Prozesses liegt im Rezipienten eine Argonatmosphäre mit einem Druck von 10 mbar vor.

**Patentansprüche**

1. Verfahren zur Herstellung von grob- bis einkristallinen vorzugsorientierten Folien oder Platten aus Halbleitermaterial durch Aufbringen von schmelzflüssigem Halbleitermaterial auf einen Substratkörper unter anschließendem gerichtetem Erstarren und nachfolgender selbsttätiger Ablösung des aufgebrachten Halbleitermaterials, dadurch gekennzeichnet, daß geschmolzenes Halbleitermaterial mit einem aus dem selben, grob- bis einkristallinen Halbleitermaterial bestehenden, mit einer Geschwindigkeit von mindestens 75 mm/s vorbeigeführten Substratkörper in Kontakt gebracht wird und daß zur selbsttätigen Ablösung der aufwachsenden Folie oder Platte der Substratkörper auf einer Temperatur von höchstens 0,8 $T_M$ gehalten wird, wobei $T_M$ der in Kelvin ausgedrückte Schmelzpunkt des eingesetzten Halbleitermaterials ist.

2. Verfahren nach Anspruch 1, dadurch gekennzeichnet, daß geschmolzenes Halbleitermaterial und Substratkörper über einen Schmelzmeniskus in Kontakt gebracht werden.

3. Verfahren nach Anspruch 2, dadurch gekennzeichnet, daß der Meniskus des geschmolzenen Halbleitermaterials mit Hilfe einer schlitzartigen Öffnung erzeugt wird.

4. Verfahren nach einem oder mehreren der Ansprüche 1 bis 3, dadurch gekennzeichnet, daß die Schmelze aus Halbleitermaterial auf einer mindestens 5 °C über ihrem Schmelzpunkt liegenden Temperatur gehalten wird.

5. Verfahren nach einem oder mehreren der Ansprüche 1 bis 4, dadurch gekennzeichnet, daß durch die Geschwindigkeit des Substratkörpers die Dicke der Folie oder Platte aus Halbleitermaterial geregelt wird.

6. Verfahren nach einem oder mehreren der Ansprüche 1 bis 5, dadurch gekennzeichnet, daß als Halbleitermaterial Silicium verwendet wird.

7. Verwendung eines Verfahrens nach einem oder mehreren der Ansprüche 1 bis 6 zur Herstellung eines Halbleitermaterials zur Erzeugung von Solarzellen.

**Claims**

1. Process for the manufacture of coarsely crystalline to mono-crystalline sheets and/or plates of semiconductor material of preferred orientation by applying molten semiconductor material to a substrate with subsequent controlled solidification and subsequent automatic release of the applied semiconductor material, characterised in that molten semiconductor material is brought into contact with a substrate of the same coarsely crystalline to monocrystalline semiconductor material that is guided past the point of contact at a speed of at least 75 mm/s, and in that, in order to ensure the automatic release of the growing sheet or plate, the substrate is maintained at a temperature of not more than 0.8 $T_M$, where $T_M$ denotes the melting point of the semiconductor material expressed in degrees Kelvin.

2. Process according to claim 1, characterised in that the molten semiconductor material, and the substrate are brought into contact with one another by means of a melt meniscus.

3. Process according to claim 2, characterised in that the meniscus of the molten semiconductor material is produced with the aid of a slot-like aperture.

4. Process according to one or more of claims 1 to 3, characterised in that the melt of semiconductor material is maintained at a temperature of at least 5 °C above its melting point.

5. Process according to one or more of claims 1 to 4, characterised in that the thickness of the sheet or plate of semiconductor material is determined by the speed of the substrate.

6. Process according to one or more of claims 1 to 5, characterised in that silicon is used as the semiconductor material.

7. Use of a process according to one or more of claims 1 to 6 for the manufacture of a semiconductor material for the production of solar cells.

**Revendications**

1. Procédé pour préparer des feuilles ou plaques en cristaux grossiers à monocristallins, à orientation préférentielle, en une matière semi-conductrice, par application de la matière semi-conductrice, liquéfiée par fusion, sur un corps de substrat avec solidification subséquente et détachement automatique subséquent de la matière semi-conductrice ainsi appliquée, procédé caractérisé en ce qu'on met en contact la matière semi-conductrice fondue, avec un corps de support consistant en la même matière semi-conductrice, en cristaux grossiers ou monocristalline, que l'on déplace à une vitesse d'au moins 75 mm/sec, et en ce que, pour un détachement automatique de la feuille ou plaque en croissance, on maintient le corps de substrat à une température d'au maximum 0,8 $T_M$, où $T_M$ représente le point de fusion, exprimé en kelvins, de la matière semi-conductrice utilisée.

2. Procédé selon la revendication 1, caractérisé en ce qu'on met en contact, par l'intermédiaire d'un ménisque fondu la matière semi-conductrice fondue et le corps de substrat.

3. Procédé selon la revendication 2, caractérisé en ce qu'on obtient, à l'aide d'une ouverture en forme de fente, le ménisque de la matière semi-conductrice fendue.

4. Procédé selon une ou plusieurs des revendications 1 à 3, caractérisé en ce qu'on maintient la masse fondue de la matière semi-conductrice à une température se situant au moins à 5 °C au-dessus du point de fusion de cette matière.

5. Procédé selon une ou plusieurs des revendications 1 à 4, caractérisé en ce qu'on règle, par la vitesse de déplacement du corps de substrat, l'épaisseur de la feuille ou plaque en matière semi-conductrice.

6. Procédé selon une ou plusieurs des revendications 1 à 5, caractérisé en ce qu'on utilise le silicium comme matière semi-conductrice.

7. Utilisation d'un procédé selon une ou plusieurs des revendications 1 à 6 pour préparer une matière semi-conductrice en vue de produire des piles solaires.

Fig. 1

0 072 565

# *Fig. 2*